# EUROPEAN PATENT SPECIFICATION

(11) **EP 3 157 171 B1**
(45) Date of publication and mention of the grant of the patent: **03.06.2020**
(21) Application number: 15306640.2
(22) Date of filing: 15.10.2015
(51) Int. Cl.: H03K 19/177

(54) **LOGIC BLOCK ARCHITECTURE FOR PROGRAMMABLE GATE ARRAY**
LOGISCHE BLOCKARCHITEKTUR FÜR EIN PROGRAMMIERBARES GATE-ARRAY
ARCHITECTURE DE BLOCS LOGIQUES POUR RÉSEAU DE PORTES PROGRAMMABLE PAR L'UTILISATEUR

(43) Date of publication of application: 19.04.2017
(73) Proprietor: MENTA, 34960 Montpellier Cedex 2 (FR)
(72) Inventor: ROUGE, Laurent, 34960 MONTPELLIER CEDEX 2 (FR); EYDOUX, Julien, 34960 MONTPELLIER CEDEX 2 (FR); MARTHELY, Serge Alexandre, 34960 MONTPELLIER CEDEX 2 (FR)
(74) Representative: Nguyen-Van-Yen, Christian

(56) References cited:
- EP-A1- 1 770 865
- WO-A1-2009/100564
- US-B1- 6 556 042

## Description

### Field of the invention

The present invention relates to programmable logic devices, and more particularly to field programmable gate array devices.

### Background of the invention

FPGAs are a type of Programmable Logic Device. They are generally based on a standard programmable Logic Block, a large number of which are arranged together to implement various functions.

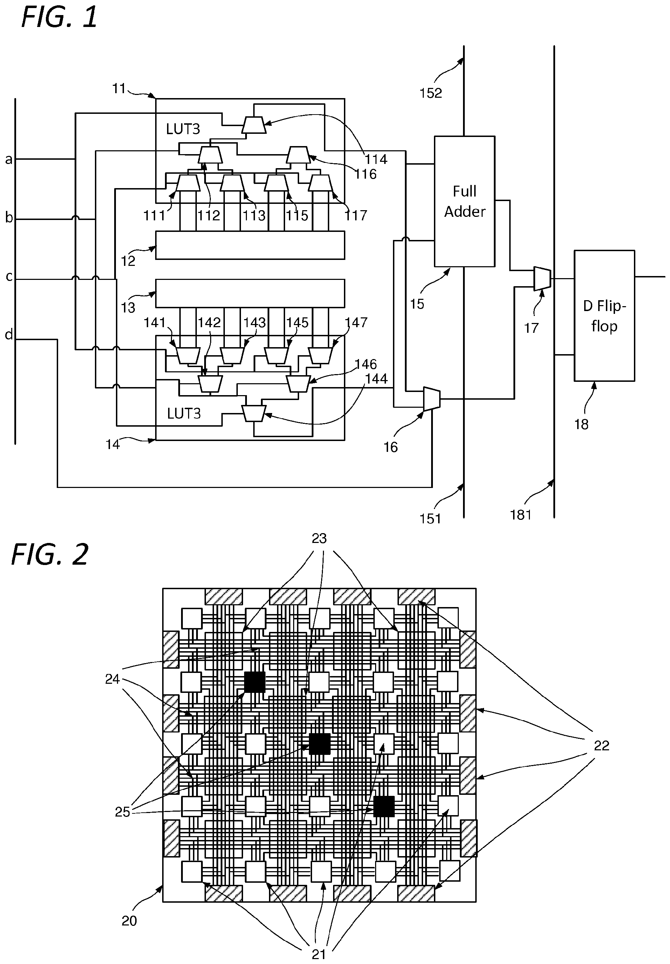

Figure 1 shows an example Logic Block belonging to the state of the art.

As shown in figure 1, the Logic block comprises a first Look Up Table (LUT) 11, and a second Look Up Table (LUT) 14. Each LUT comprises seven two input multiplexers 111, 112, 113, 114, 115, 116, 117 and 141, 142, 143, 144, 145, 146, 147 respectively. These multiplexers are arranged in a cascading manner with three rows so as to constitute an 8 input multiplexer, the output of which constitutes the output of the LUT. The first row of multiplexers (111, 113, 115 and 117, and 141, 143, 145 and 147) in each cascade arrangement both have a total of eight inputs. These eight inputs constitute the programming inputs of each LUT respectively. The selection inputs of each row are ganged together, to constitute the three data inputs of each LUT. Conventionally a LUT with 3 data inputs in this manner is referred to as a "LUT3". As shown, each input of a respective LUT is tied to a corresponding input of the other, and both inputs connected to a corresponding input a, b or c of the Logic Block itself. The eight programming inputs of each LUT 11 and 14 are connected to a memory device 12 and 13 respectively. In operation, these memory devices 12, 13 provide a constant predetermined logical value to each of the eight programming inputs of each LUT. By selecting the predetermined logical value provided at each input, the logical behaviour of the LUT is response to any binary value on its three data inputs can be defined as required. This is the underlying basic concept of FPGA technology. Generally, the values in the memories 12, 13 corresponding to the desired predetermined logical value on each LUT programming input are loaded from a non-volatile memory (not shown) each time the device is turned on. The fact that these values can be selected to provide any desired functionality without changing the device hardware, and that the values can be modified to provide bug fixes or functional improvements simply by replacing the information in the non-volatile memory are key advantages of the FPGA technology. It will be appreciated however that the functions that a single Logic block comprising two LUT3s can implement is limited, and the remaining feature of the Logic block shown in figure 1 are intended to expand this capacity. A multiplexer 16 is provided connecting the outputs of the two LUTs 11 and 14, and switched by a fourth input d of the Logic Block. When the outputs of the two LUTs are coupled in this manner, the two LUT3s become logically equivalent to a LUT4. Meanwhile, there is provided a one bit Full Adder 15, configured to add the values output from the two LUTs 11 and 14. The Carry in 151 and Carry Out 152 connections of the Full adder 15 are connected to neighbouring Logic Blocks (not shown), so that by using multiple adjacent blocks binary values of any size may be added. A final Multiplexer 17 is provided to select between the outputs of the Full Adder 15 and the Multiplexer 16, and correspondingly select between the Logic Block behaving as a LUT4 on one hand, or two LUT3s with Added outputs on the other. Finally, there is provided a D flip-flop 18, configured to receive the output of the multiplexer, 17, and to pass this to the D output on detecting a pulse on its clock input 181. The clock input 181 is shared across multiple adjacent Logic blocks, so that regardless of the logical processing taking place within the block, every block can be controlled to produce its output at a predetermined, coordinated time.

As mentioned above, for a FPGA system to offer useful functionality it is usually necessary to associate a large number of Logic Blocks.

Figure 2 shows schematically an example of an FPGA system as known in the state of the art.

As shown in figure 2, an FPGA chip 20 comprises a number of Logic Blocks 21, for example as described above. The chip also comprises a number of input/output ports 22. Connecting these logic blocks 21 and input/output ports 22 are a number of tracks 24. At junction points of these tracks are provided and number of programmable routing areas 23. In these programmable routing areas there are provided switches which can selectively connect any pair of intersecting tracks, under the control of a logical value stored in a memory cell connected with each switch. In a similar manner to that described above for the programming of the memory units 12 and 13, the switch memory values are set at system start up from a non volatile memory. Accordingly, by setting the values in the switch memories as required, and the connections of any Logic Block can be coupled to those of any other Logic Block, or any input/output port 22. Thus, by properly configuring the memory units 12 and 13 to define the operation of each logic block, and the switch memories 23 to establish appropriate connections between the logic blocks, any desired functionality can be implemented.

It will be appreciated that while the arrangement described above is extremely versatile, it will also be subject to a number of inefficiencies in terms of speed, energy consumption and surface area. These arise for a number of reasons. Firstly, it will generally not be possible to map the desired function onto the available circuits with perfect efficiency- there will always be some redundant elements. Secondly, the implementation of a particular function with generic circuits will often be less efficient in terms of (for example) the number of transistors used, that a circuit designed specifically to perform that function.

While these inefficiencies are to some degree inherent in the underlying approach of FPGA technology as compared to application-specific integrated circuits, it is nevertheless desirable to minimize these so far as possible.

In recent years, it has become increasingly common to include more specialized circuits in the same system, optimized to perform memory, DSP, coding/decoding or encryption functions, for example. As shown in figure 2 for example, the blocks 25 may be set aside for such specialized purposes. These FPGA systems are tending to move away from their pure reconfigurable/application agnostic roots and adopt certain aspects of ASIC technologies in order to offer performance closer to that of pure ASIC solutions.

US6798240 and US5414377 A, US 5889413 A and WO 2012123243 A1 describe related approaches in this domain.

WO 2009100564 A1 describes an Integrated circuits with improved logic cells in which an integrated circuit having a plurality of logic cells is provided, each logic cell comprising: a lookup table having a LUT output terminal; and, a first multiplexer: wherein, a first multiplexer input terminal is connected to a first input terminal of the logic cell, a second multiplexer input terminal is connected to the LUT output terminal, a multiplexer output terminal is connected to a first output terminal of the logic cell, and a multiplexer select terminal is connected to a second input terminal of the logic cell so as to select which of the signals appearing at the first and second multiplexer input terminal to pass through; wherein, by coupling in chain the first input terminal of one logic cell to the first output terminal of another logic cell, a WLUT chain is formed.

It is desirable to improve the efficiency of FPGA systems, whilst maintaining their versatility.

### Summary of the invention

The invention is defined in the independent claims. According to a first aspect of the invention there is provided a programmable logic block comprising a first LUT having a first plurality of data inputs, a second plurality of configuration inputs, and a third plurality of outputs, a second LUT having a fourth plurality of data inputs and a fifth plurality of configuration inputs, and a sixth plurality of outputs, said programmable logic block characterized by further comprising a programmable controller having a respective output connecting to each of said second plurality of configuration inputs and each of said fifth plurality of configuration inputs respectively, a seventh plurality of configuration memory cells, and an eighth plurality of data entries, wherein the value of each of said second plurality of configuration inputs and said fifth plurality of configuration inputs is dictated by the value present on each of said eighth plurality of data entries together with the value of said seventh plurality of configuration memory cells in a predetermined manner.

This programmable logic device is highly flexible and capable of implementing a wide range of advanced processing functions, whilst having a low impact on gate count and surface area requirements when compared more specialized circuitry in FPGA solutions.

According to a development of the first aspect of the invention the programmable logic block further comprises a logic circuit connected to each of said third plurality of outputs and said sixth plurality of outputs, said logic circuit adapted to combine said outputs to implement a specified data processing function.

By adding such a logic circuit, the functionality of the device is further enhanced, further improving, the compromise between, gate count and surface area requirements on one hand and functionality on the other.

According to a further development of the first aspect of the invention the programmable logic block the logic circuit comprises components for the implementation of a plurality of data processing functions, and further comprises one or more memory cells coupled respectively to components of said logic circuit so as to programmably select said specified data processing functions from said plurality of data processing functions.

By optimizing the logic circuit for a number of common special functions, the functionality of the device is further enhanced, further improving the compromise between, gate count and surface area requirements on one hand and functionality on the other.

According to a further development of the first aspect of the invention the plurality of data processing functions includes the functionality of a 1 bit full adder. This common functionality will be useful in may FPGA implementations, reducing gate count and surface area requirements when compared to generic FPGA implementations.

According to a further development of the first aspect of the invention the plurality of data processing functions includes the functionality of a 2 bit full adder. This common functionality will be useful in may FPGA implementations, reducing gate count and surface area requirements when compared to generic FPGA implementations.

According to a further development of the first aspect of the invention the plurality of data processing functions includes the functionality of a multiplexer whose width is greater than said second plurality. This common functionality will be useful in may FPGA implementations, reducing gate count and surface area requirements when compared to generic FPGA implementations.

According to a further development of the first aspect of the invention the plurality of data processing functions includes the functionality of a LUT having a number of data inputs greater than said second plurality. This common functionality will be useful in may FPGA implementations, reducing gate count and surface area requirements when compared to generic FPGA implementations.

According to a further development of the first aspect of the invention the programmable controller comprises a plurality of programmable controller LUTs, and where each of the outputs of said programmable controller corresponds to a respective output of one of said programmable controller LUTs, where the configuration inputs of each said programmable controller LUT is coupled to a respective one of said seventh plurality of configuration memory cells. This architecture offers exceptional flexibility with basic and well understood component libraries.

According to a further development of the first aspect of the invention the data inputs of said programmable controller LUTs are coupled to said eighth plurality of data entries of said programmable controller. This one to one mapping provides a simple yet flexible structure.

According to a further development of the first aspect of the invention the programmable controller further comprises a decoder configured to decode the eighth plurality of data entries, wherein the programmable controller further comprises a plurality of switching boxes, each switching box receiving each of the decoded outputs of said decoder, and a respective one of said seventh plurality of said configuration memory cells, whereby each switching box provides an output value to one of the outputs connecting to each of said second plurality of configuration inputs and the fifth plurality of configuration inputs respectively, where the value of the output is equal to the combination by a logical OR of the logical AND of each of the decoded output of the decoder with a respective one of said second plurality of configuration inputs.

This structure provides a powerful and flexible manner for supporting the programmable operation of the LUTs and logic with a minimal cost in terms of surface area, and use of standard circuit elements.

According to a further development of the first aspect of the invention the programmable controller has four data entries, of which two are coupled in common to two respective data inputs of each of said programmable controller LUTs, and a third one of said entries is coupled in common to a third respective input of each of said programmable controller LUTs whose output corresponds to a configuration input of said first LUT, and a fourth one of said entries is coupled in common to a third respective input of each of said programmable controller LUTs whose output corresponds to a configuration input of said second LUT. The sharing of inputs in this way makes the most of the functionality available whilst controlling any increase in surface area requirements due for example to signal tracks.

According to a further development of the first aspect of the invention a first one of said third plurality of outputs of said first LUT corresponds to any of said second plurality of inputs multiplexed by each of said first plurality of data inputs, and a second one of said third plurality of outputs of said first LUT corresponds to any of a subset of said second plurality of inputs multiplexed by a subset of said first plurality of data inputs, or a first one of said sixth plurality of outputs of said second LUT corresponds to any of said fifth plurality of inputs multiplexed by each of said fourth plurality of data inputs, and a second one of said sixth plurality of outputs of said second LUT corresponds to any of a subset of said fifth plurality of inputs multiplexed by a subset of said fourth plurality of data inputs. Accessing different parts of the LUT in this way opens up further options for extending the functionality of the device with little or no increase in gate count or surface area.

According to a second aspect of the invention there is provided a method of operating an FPGA device comprising a first LUT, a second LUT and a programmable controller. The method comprises the steps of setting the values of a first plurality of memory cells associated with said programmable controller, and then enabling the FPGA. The method then proceeds to provide a data input to the programmable controller, whereby the programmable controller sets configuration values of the first LUT and the second LUT as a function of the data input and the values of the first plurality of memory cells. Furthermore, a data input is provided to the first LUT and the second LUT. The first LUT and the second LUT perform respective logic operations on the respective data inputs as a function of the configuration values set by said programmable controller; and then output the result. This method provides for programming of an FPGA with the advanced features of the invention to be programmed as easily as an entirely generic FPGA architecture.

According to a development of the second aspect of the FPGA device further comprises a logic circuit, and the method comprises the further step of setting the values of a second plurality of memory cells associated with the configuration inputs of said logic circuit prior to said step of enabling said FPGA. The step of providing a data input to the first LUT and the second LUT further comprises providing a data input to said logic circuit, and in a further step the logic circuit performs a further logic operation on the outputs of the first LUT and said second LUT as a function of the values of the second plurality of memory cells, and outputs the result.

This method provides for further flexibility in terms of the operations that the device may implement.

According to a third aspect of the invention there is provided a datastream comprising values selected to implement the method of the second aspect of the invention. By this means, the complete configuration of an FPGA in accordance with the present invention can be defined and stored in a purely digital form.

### Brief Description of the Drawings

The above and other advantages of the present invention will now be described with reference to the accompanying drawings, in which:
Figure 1 shows an example Logic Block belonging to the state of the art;
Figure 2 shows schematically an example of an FPGA system as known in the state of the art;
Figure 3 shows a first embodiment;
Figure 4 shows a second embodiment;
Fig 5 shows further detail of the combinatorial logic 45 of the embodiment described with reference to figure 4;
Fig 6 shows further detail of the combinatorial logic 45 of the embodiment described with reference to figure 4;
Fig 7 shows further detail of the combinatorial logic 45 of the embodiment described with reference to figure 4;
Fig 8 shows further detail of the combinatorial logic 45 of the embodiment described with reference to figure 4;
Fig 9 shows further detail of the combinatorial logic 45 of the embodiment described with reference to figure 4;
Figure 10 shows details of the implementation of the programmable controller according to an embodiment;
Figure 11 shows details of the implementation of the programmable controller according to a further embodiment;
Figure 12 shows the steps of a method of operating an FPGA device in accordance with an embodiment; and
Figure 13 shows the steps of a further method of operating an FPGA device in accordance with an embodiment.

### Detailed description

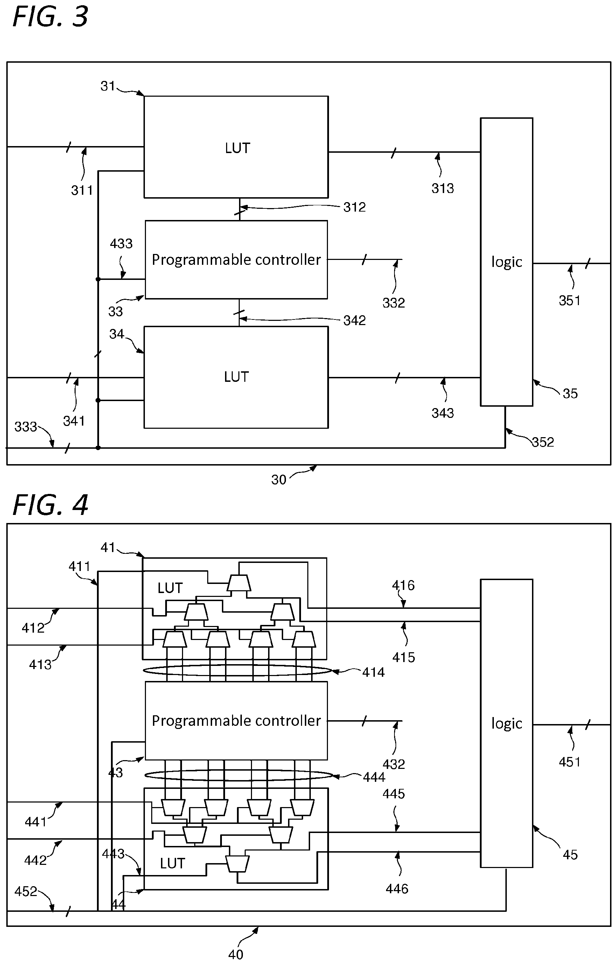

Figure 3 shows a first embodiment. As shown in figure 3, there is provided a programmable logic block 30 comprising a first Look Up Table (LUT) 31 having a set of data inputs 311, a set of configuration inputs 312, and an output 313, and a second LUT 34 having a set data inputs 341, a set of configuration inputs 342, and an output 343. The first and second LUT 31 and 34 may be of any size, and may be of different sizes. The number of data inputs 311, 341, and the number of configuration inputs 312, 242 will vary depending on the size of the two LUTs.

The programmable logic block 30 further comprises a programmable controller 33 having an output connecting to each of the configuration inputs 312 of the first LUT 31 and each of the configuration inputs 342 of the second LUT 34. The programmable Logic Block 30 also has a set of configuration inputs 332, each coupled to a memory cell (not shown), and an eighth plurality of data entries, some or all of which may be common width input connections 333 shared with the combinatorial logic 35 described below. The number of configuration inputs 332 and data inputs 331 depends on the specific configuration of the Programmable controller 33, and the functions to be implemented by the programmable logic block 30, for which a number of non-limiting examples are set out in the following embodiments.

Accordingly, while in conventional logic blocks for example as described with reference to figure 1 the functionality of any given block is fixed at startup when the values of the memory 12, 13 are set, the functions of the logic block of the present embodiment can be reset to any of a number of specified options depending on the values received on the input pins of the programmable controller 33. These options may extend beyond the basic capabilities of standard LUTs of whatever size is specified, due to the extended functionality enabled by the logic block 35, as described further below.

There is accordingly disclosed a programmable logic block comprising a first LUT having a first plurality of data inputs, a second plurality of configuration inputs, and a third plurality of outputs, and a second LUT having a fourth plurality of data inputs and a fifth plurality of configuration inputs, and a sixth plurality of outputs, said programmable logic block characterized by further comprising

In this embodiment, the first and second LUTs are both LUT3s, having eight configuration inputs and 3 data inputs, however it will be appreciated that LUTs of any size, and of two different sizes may be used.

There is furthermore provided a programmable controller having an output connecting to each of said second plurality of configuration inputs and said fifth plurality of configuration inputs respectively, a seventh plurality of configuration memory cells, and an eighth plurality of data entries, wherein the value of each of the second plurality of configuration inputs and the fifth plurality of configuration inputs is dictated by the value present on each of the eighth plurality of data entries together with the value of said seventh plurality of configuration memory cells in a predetermined manner.

In accordance with this embodiment, the programmable logic block further comprises combinatorial logic 35 connected to each of said set of outputs 313 from the first LUT 31 and the set of outputs 343 from the second LUT 34, said combinatorial logic 35 adapted to combine the outputs 313, 343 to implement a specified data processing function in response to a value on said data inputs 352, for example as described below.

It will be understood, as described in more detail hereafter, that the programmable logic block is optional.

In this case, the programmable logic block further comprises a logic circuit connected to each of the third plurality of outputs and said sixth plurality of outputs, this logic circuit being adapted to combine said outputs to implement a specified data processing function.

There follow some examples of the data processing functions that may be implemented in accordance with certain embodiments.

### Logic functions

1 bit full adder: values A, B and Cin are received on specified respective data inputs 341, and the outputs 351 carry the values of Cout and S in accordance with the truth table below.

| **Inputs** | | | **Outputs** | |
|---|---|---|---|---|
| ***A*** | ***B*** | ***C*ᵢₙ** | ***C*ₒᵤₜ** | ***S*** |
| 0 | 0 | 0 | 0 | 0 |
| 1 | 0 | 0 | 0 | 1 |
| 0 | 1 | 0 | 0 | 1 |
| 1 | 1 | 0 | 1 | 0 |
| 0 | 0 | 1 | 0 | 1 |
| 1 | 0 | 1 | 1 | 0 |
| 0 | 1 | 1 | 1 | 0 |
| 1 | 1 | 1 | 1 | 1 |

2 bit full adder, values A, B and Cin are received on specified respective data inputs 311, 341, and the outputs 351 carry the values of Cout and S in accordance with the truth table below.

| A | B | Cin | Cout | S |
|---|---|---|---|---|
| 00 | 00 | 0 | 0 | 00 |
| 00 | 01 | 0 | 0 | 01 |
| 00 | 10 | 0 | 0 | 10 |
| 00 | 11 | 0 | 0 | 11 |
| 01 | 00 | 0 | 0 | 01 |
| 01 | 01 | 0 | 0 | 10 |
| 01 | 10 | 0 | 0 | 11 |
| 01 | 11 | 0 | 1 | 00 |
| 10 | 00 | 0 | 0 | 10 |
| 10 | 01 | 0 | 0 | 11 |
| 10 | 10 | 0 | 1 | 00 |
| 10 | 11 | 0 | 1 | 01 |
| 11 | 00 | 0 | 0 | 11 |
| 11 | 01 | 0 | 1 | 00 |
| 11 | 10 | 0 | 1 | 01 |
| 11 | 11 | 0 | 1 | 10 |
| 00 | 00 | 1 | 0 | 01 |
| 00 | 01 | 1 | 0 | 10 |
| 00 | 10 | 1 | 0 | 11 |
| 00 | 11 | 1 | 1 | 00 |
| 01 | 00 | 1 | 0 | 10 |
| 01 | 01 | 1 | 0 | 11 |
| 01 | 10 | 1 | 1 | 00 |
| 01 | 11 | 1 | 1 | 01 |
| 10 | 00 | 1 | 0 | 11 |
| 10 | 01 | 1 | 1 | 00 |
| 10 | 10 | 1 | 1 | 01 |
| 10 | 11 | 1 | 1 | 10 |
| 11 | 00 | 1 | 1 | 00 |
| 11 | 01 | 1 | 1 | 01 |
| 11 | 10 | 1 | 1 | 10 |
| 11 | 11 | 1 | 1 | 11 |

Full width multiplexer: the first and second LUTs 31, 34 are configured as multiplexers, and their outputs multiplexed together, so that the value on any of the inputs 311, 341 can be selected, and made available at the output 351. On this basis, the system may implement a multiplexer of any size, including multiplexers having a width greater than the number of data inputs of one of the first or second LUTs.
determination of equality: the first and second LUTs 31, 34 are configured as XNORs, and their outputs combined with further logic, so that the value on any of the inputs 311, 341 can be selected, and made available at the output 351. Accordingly, the system may offer the functionality of determining whether a first binary number having a number of bits equal or less than the number of data inputs of the first LUT is identical to a second binary number having a number of bits equal or less than the number of data inputs of the second LUT.

Comparator: the first LUTs 34 is configured as an XNOR, and its output processed together with its inputs by the combinatorial logic, so that the value on the output 351 indicates whether one input is greater than the other, as indicated in the truth table below.

| A | B | Z |
|---|---|---|
| 0 | 0 | 1 |
| 0 | 1 | 0 |
| 1 | 0 | 1 |
| 1 | 1 | 1 |

Accordingly, the system can offer the functionality of a determination whether a first binary number having a number of bits equal or less than the number of data inputs of the first LUT is in a first case more than or equal to a second binary number, or in a second case less than said second binary number.

Extended LUT: The Programmable controller itself implements LUT functionality. By using inputs of the programmable controller in addition to those of the LUTs 41, 44, is possible to provide the functionality of larger LUTs. This expansion may be attributed to one LUT or the other, split between them, or shared by both as common inputs. By this means, the logic block can provide functionality as follows in addition to the basic 2LUT3 configuration:

| **LUT config 1** | **LUT config 2** | **Number of Common Inputs** |
|---|---|---|
| LUT6 | LUT6 | 2 |
| LUT6 | LUT5 | 1 |
| LUT6 | LUT4 | 0 |
| LUT6 | LUT3 | 0 |
| LUT5 | LUT5 | 0 |
| LUT5 | LUT4 | 0 |
| LUT5 | LUT3 | 0 |
| LUT4 | LUT4 | 0 |
| LUT4 | LUT3 | 0 |
| LUT3 | LUT3 | 0 |

Additional functions such as subtraction may be implemented, as may any arbitrary logic implementable using the LUTs.

| A | B | Cin | Cout | S |
|---|---|---|---|---|
| 00 | 00 | 0 | 0 | 11 |
| 00 | 01 | 0 | 0 | 01 |
| 00 | 10 | 0 | 0 | 11 |
| 00 | 11 | 0 | 0 | 00 |
| 01 | 00 | 0 | 1 | 01 |
| 01 | 01 | 0 | 0 | 11 |
| 01 | 10 | 0 | 1 | 00 |
| 01 | 11 | 0 | 0 | 10 |
| 10 | 00 | 0 | 1 | 00 |
| 10 | 01 | 0 | 0 | 10 |
| 10 | 10 | 0 | 0 | 11 |
| 10 | 11 | 0 | 0 | 01 |
| 11 | 00 | 0 | 1 | 10 |
| 11 | 01 | 0 | 1 | 00 |
| 11 | 10 | 0 | 1 | 01 |
| 11 | 11 | 0 | 0 | 01 |
| 00 | 00 | 1 | 1 | 00 |
| 00 | 01 | 1 | 0 | 10 |
| 00 | 10 | 1 | 0 | 11 |
| 00 | 11 | 1 | 0 | 01 |
| 01 | 00 | 1 | 1 | 10 |
| 01 | 01 | 1 | 1 | 00 |
| 01 | 10 | 1 | 1 | 01 |
| 01 | 11 | 1 | 0 | 11 |
| 10 | 00 | 1 | 1 | 01 |
| 10 | 01 | 1 | 0 | 11 |
| 10 | 10 | 1 | 1 | 00 |
| 10 | 11 | 1 | 0 | 10 |
| 11 | 00 | 1 | 1 | 11 |
| 11 | 01 | 1 | 1 | 01 |
| 11 | 10 | 1 | 1 | 10 |
| 11 | 11 | 1 | 1 | 00 |

It will be appreciated that these logical functions are merely examples, and that many other logical functions may advantageously be implemented with a combination of one or both LUTs and suitable combinatorial logic and the programmable controller, under the control of the respective configuration memories. The described approach can lead to timing performance improvements of applications mapped onto FPGA incorporating programmable logic blocks according to the embodiment, as compared to the performance that may be achieved with conventional logic blocks for example as described with respect to figure 1.

The described approach can lead to improved area efficiency for complex functions implemented in an FPGA incorporating programmable logic blocks according to the embodiment, as compared to the performance that may be achieved with conventional logic blocks for example as described with respect to figure 1.

The described approach can lead to improved power optimization since fewer resources used in functions implemented in an FPGA incorporating programmable logic blocks according to the embodiment, as compared to the performance that may be achieved with conventional logic blocks for example as described with respect to figure 1.

Generally, a reduction in area/timing gap between ASIC and FPGA, and improved Mapping efficiency achieved based on the described embodiment lead to both cost reduction and improved performance as compared to the performance that may be achieved with conventional logic blocks for example as described with respect to figure 1.

Figure 4 shows a second embodiment. The embodiment of figure 4 is a development of that of figure 3, in which the first and second LUTs are two conventional LUT3s. As shown in figure 4, there is provided a programmable logic block 40 comprising a first LUT3 41 having by definition a set of three data inputs 411, 412, 413, and correspondingly 2^3= 8 configuration inputs 414, and a single output 416, and a second LUT3 44 by definition a set of three data inputs 441, 442, 443, and correspondingly 2^3= 8 configuration inputs 444 and a single output 446. The first LUT 41 is illustrated as comprising seven two input multiplexers in the same way as the LUT3s 11 and 14 described with respect to figure 1. These multiplexers are arranged in a cascading manner with three rows so as to constitute an 8 input multiplexer. Unlike the LUT3s of figure 1 however, the LUT3s 41 and 44 of figure 4 each comprise an additional output 415 and 445 respectively, coupled respectively to the output of one of the two two-way multiplexers constituting the second row of Multiplexers of each LUT 41 and 44. As described below, this additional feature can be helpful in implementing some additional logic functions of the circuit.

The programmable logic block 40 further comprises a programmable controller 43 having an output connecting to each of the configuration inputs 414 of the first LUT 41 and each of the configuration inputs 444 of the second LUT 44. The programmable Logic Block 40 also has a set of configuration inputs 432, each coupled to a memory cell (not shown), and plurality of data entries 433. Data input may also be received from one or more input connections 452 shared with the combinatorial logic 45 described below. The number of configuration inputs 432 and data inputs 433 depends on the specific configuration of the Programmable controller 43, and the functions to be implemented by the programmable logic block 40, for which a number of non-limiting examples are set out in the following embodiments.

In accordance with this embodiment, the programmable logic block further comprises combinatorial logic 45 connected to each of said the set of outputs 415, 416 from the first LUT 41 and the set of outputs 445, 446 from the second LUT 44, said combinatorial logic 45 adapted to combine the outputs 415,416, 445, 446 to implement a specified data processing function in response to one or more values on said data inputs 452, for example as described below.

The value present on each of the programmable logic block data entries 433 dictates the value of each of the eight configuration inputs 414 of the first LUT 41 and each of the eight configuration inputs 444 of the second LUT 44 as a function of the values of each the configuration inputs 432 of the programmable controller 43.

In accordance with this embodiment of the invention, the programmable logic block further comprises combinatorial logic 45 connected to each of the outputs 415, 416 of the first LUT 41 and each of the outputs 445, 446 of the second LUT 44, and having outputs 451, where the combinatorial logic 45 is adapted to combine the outputs of the first LUT 41 and second LUT 44 to implement a specified data processing function in response to a value on the data inputs 452, for example as listed with respect to the first embodiment above, and described in further detail below.

It will be appreciated that the specific contents and configuration of the combinatorial logic 45 will vary depending on the specific set of logical functions to be implemented. By way of example, a number of possible configurations are set out in the following embodiments. For the sake of simplicity these examples are set out in the context of the embodiment of figure 4, however it will be appreciated that these implementations are directly adaptable to any other embodiment.

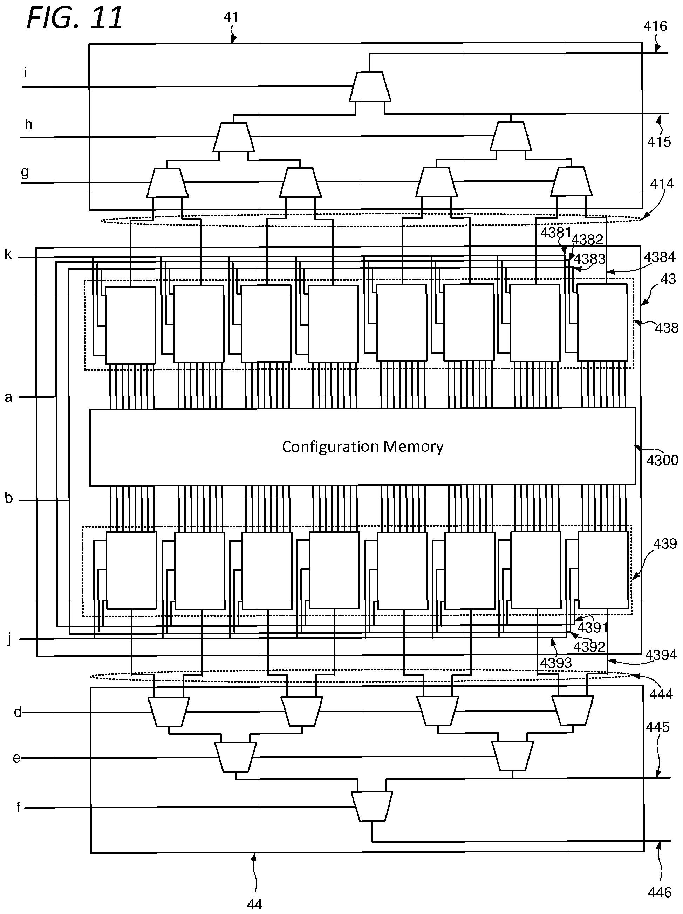

Furthermore, it will be appreciated that certain functions can be implemented without recourse to the use of the combinatorial logic block 45. For example, the arrangement shown in figure 4 can be configured to implement two six-input Look-up tables (LUT6) with two common inputs simply by suitably configuring the programmable controller as explained in detail below with reference to figure 11.

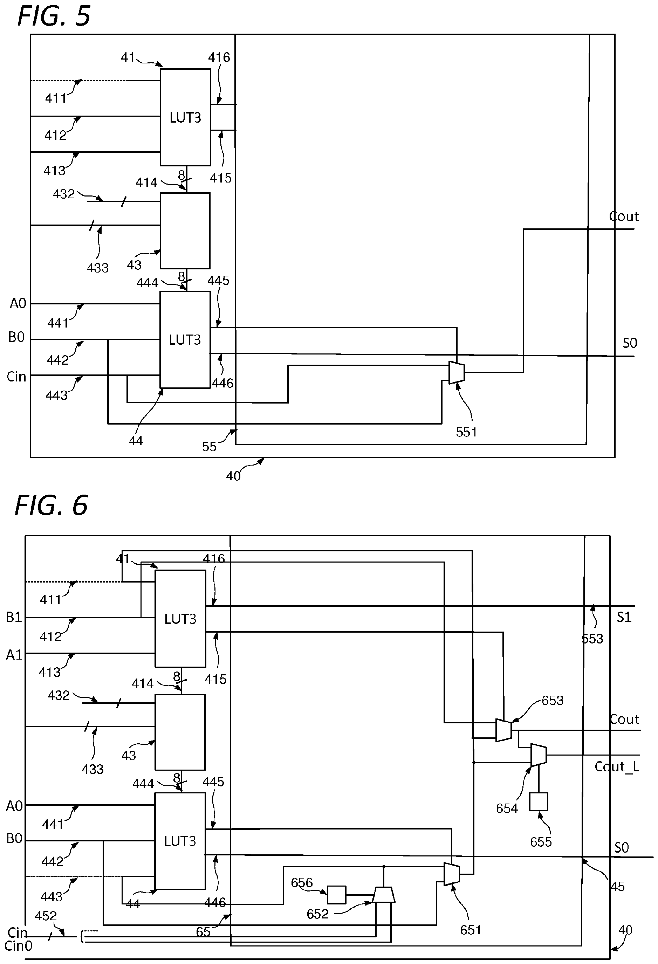

Fig 5 shows further detail of the combinatorial logic 45 of the embodiment described with reference to figure 4. In the embodiment of figure 5, the combinatorial logic is arranged to implement a 1 bit adder. As shown in figure 5, the LUTs 41 and 44 and the programmable controller 43 are configured as described with reference to figure 4. The combinatorial logic 55 comprises a two way multiplexer 551, which receives data inputs from the inputs 442 and 443 (corresponding to the data inputs for the second and last rows respectively of the Multiplexer array of the LUT) of the second LUT 44. The output 445, corresponding to the output of one group of multiplexers in the second row as described above), provides the switching signal to the multiplexer 551 to as to select between the two input values on inputs 443 and 442. The values of the eight configuration inputs 444 of the LUT 44 are set to 01101001 in sequence. In this arrangement, the input 441 corresponds to the A adder input, input 442 corresponds to Adder input B, and input 443 corresponds to the carry in input as describes with reference to the Adder truth table above. Accordingly the LUT 44 implements an XOR function as follows, and as such provides the S output of the adder output 446. The second row output 445 of the LUT switches the multiplexer 551 to select the value from the inputs 442, 443 which corresponds to the required carry out value.

Fig 6 shows further detail of the combinatorial logic 45 of the embodiment described with reference to figure 4. In the embodiment of figure 6, the combinatorial logic is arranged to implement a 2 bit adder. As shown in figure 6, the LUTs 41 and 44 and the programmable controller 43 are configured as described with reference to figure 4. The combinatorial logic 65 comprises a two way multiplexer 651, which receives data inputs from the inputs 442 and 443 (corresponding to the data inputs for the second and last rows respectively of the Multiplexer array of the LUT) of the second LUT 44. The combinatorial logic 65 further comprises a two way multiplexer 652, which receives data inputs Cin and CinO, which is switched to set the values on LUT 44's input pin 443. The multiplexer 652 is switched by the value stored in a memory cell 656, which is set at system initialization in the same way as LUT configuration cells or the configuration cells of the programmable controller. The values Cin and CinO are received from the Cout a further MLUT (not shown) forming part of the carry chain path. This path may be creating using the FPGA programmable routing features, or be part of a dedicated carry chain routing. The combinatorial logic 65 further comprises a two way multiplexer 653, which receives data inputs from the output of the multiplexer 651 and the second input 412 of the first LUT. The multiplexer 653 is switched by the output 415 corresponding to the output of a group of multiplexers output at the second row of the multiplexer array constituting the LUT 41. The output of the multiplexer 653 provides the output Cout of the two bit adder. The combinatorial logic 65 further comprises a two way multiplexer 654, which receives data inputs from the output of the multiplexer 653, and the multiplexer 651.

The multiplexer 654 is switched by the value stored in a memory cell 655, which is set at system initialization in the same way as LUT configuration cells or the configuration cells of the programmable controller. The output of the multiplexer 653 provides the output Cout_L of the two bit adder. The output 445, corresponding to the output of one group of multiplexers in the second row as described above), provides the switching signal to the multiplexer 651 to as to select between the two input values on inputs 443 and 442. The values of the eight configuration inputs 444 of the LUT 44 and inputs 414 of LUT 41 on Fig4 are set to 01101001 in sequence. In this arrangement, the input 441 corresponds to the A0 adder input, input 413 corresponds to the A1 adder input, input 442 corresponds to Adder input B0, and input 412 corresponds to Adder input B1. The inputs Cin and Cin0 are provided directly to multiplexer 652 via input 452.

The LUTs 44 and 41 each implement an XOR function as follows, and as such provide the S output of the adder output 446.

It will be appreciated that these same set of components can be used to implement a subtractor feature, simply be setting the values of the eight configuration inputs 444 of the LUT 44 to 10010110 in sequence instead of 01101001 as described above.

It will be appreciated that these same set of components can be used to implement a comparator feature. In this case, the LUTs are configured as XNOR gates, the values on outputs 416 and 446 can be disregarded. The outputs 415, 445 are used to switch between the Binput and the carry value as described above, and the output of the multiplexer 654 is one if B is greater than or equal to A. It will further be appreciated that while as described in this paragraph a two bit comparator is implemented, a single LUT may be used to implement a one bit comparator, leaving the other LUT free for the implementation of other features.

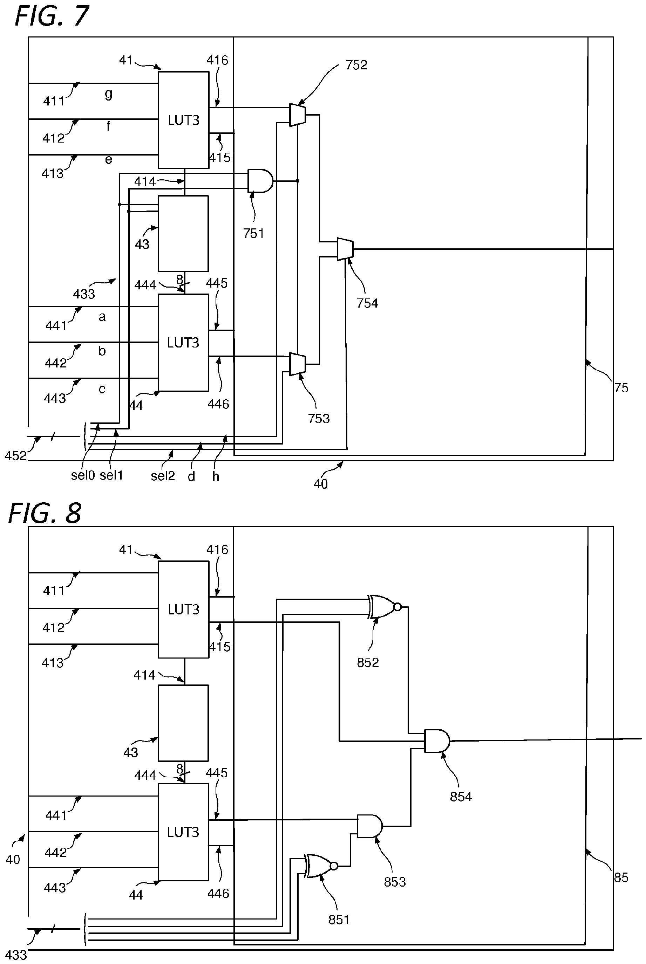

Fig 7 shows further detail of the combinatorial logic 45 of the embodiment described with reference to figure 4. In the embodiment of figure 7, the combinatorial logic is arranged to implement an 8 bit multiplexer. As shown in figure 7, the LUTs 41 and 44 and the programmable controller 43 are configured as described with reference to figure 4. The combinatorial logic 65 comprises an AND gate 751, receiving data inputs Sel0 and Sel1 from two of the external inputs 452, which are also coupled to two data inputs of the programmable controller 43. The combinatorial logic 65 comprises a multiplexer 752 receiving the output from the first LUT3 41 on one input and from a further one of the external inputs 452 on the other input. This multiplexer 752 is switched by the value output from the AND gate 751. The combinatorial logic 65 comprises a multiplexer 753 receiving the output 446 from the second LUT3 44 on one input and from a further one of the external inputs 452 on the other input. This multiplexer 753 is switched by the value output from the AND gate 751. The combinatorial logic 65 comprises a further multiplexer 754 receiving the output from the multiplexers 752 and 753, and switched by a further one of the external inputs 452 sel2. The output of the multiplexer 754 is provided at the data output of the combinatorial logic block 75. In this embodiment, the programmable sets the configuration of the LUTs 41 and 43 on the basis of the inputs Sel0 and Sel1 on the basis of the following truth table:

| Sel0 | Sel1 | LUT3 configuration inputs |
|---|---|---|
| 0 | 0 | 01010101 |
| 0 | 1 | 00110011 |
| 1 | 0 | 00001111 |
| 1 | 1 | Not used- values irrelevant |

Thus we have a device with eight data inputs a, b, c, d, e, f, g, h, which can be selected using 3 selection inputs Sel0, Sel1 and Sel2, so that the configuration described provides the functionality of an 8 bit multiplexer.

Fig 8 shows further detail of the combinatorial logic 45 of the embodiment described with reference to figure 4. In the embodiment of figure 8, the combinatorial logic is arranged to implement an equality circuit, adapted to compare two four-bit numbers, and determine whether the two are equal. As shown in figure 8, the LUTs 41 and 44 and the programmable controller 43 are configured as described with reference to figure 4. The combinatorial logic 85 comprises an XNOR gate 851, receiving data inputs from two of the external inputs 452. The combinatorial logic 85 comprises a further XNOR gate 852 receiving data inputs from a further two of the external inputs 452. The combinatorial logic 85 comprises a two input AND gate 853 receiving data inputs from the output 445 of the second LUT3 44 corresponding to a group of multiplexers outputting a value in the second row of the array of multiplexers constituting the LUT, and the output of the XNOR 851. The combinatorial logic 85 comprises a three input AND gate 854 receiving data inputs from the output 415 of the first LUT3 41 corresponding to a group of multiplexers outputting a value in the second row of the array of multiplexers constituting the LUT, the output of the XNOR 852, and the output of the AND gate 853. The two LUT3s 41 and 44 are configured by the programmable controller as XNORs, by setting the four configuration inputs corresponding to the two first row multiplexers feeding into the second row multiplexers that correspond to the second row outputs 415 and 445 respectively to 1001, as dictated by the XNOR truth table:

| a | b | XNOR |
|---|---|---|
| 0 | 0 | 1 |
| 0 | 1 | 0 |
| 1 | 0 | 0 |
| 1 | 1 | 1 |

It will be appreciated that each LUT 41, 44 can be programmed separately as a 2 bit equality circuit, potentially leaving the other LUT available for other uses. This is why as shown the AND gates 853 and 854 are shown separately, although in the absence of other circuit elements they are logically equivalent to a single 4 input AND gates.

Thus in operation in accordance with this embodiment, a bit-wise comparison is performed with a two input XNOR for each bit, and the results combined with an AND gate such that if all bits are equal, the two four bit values are equal and a one is output by the AND 854 at the output of the combinatorial logic 85.

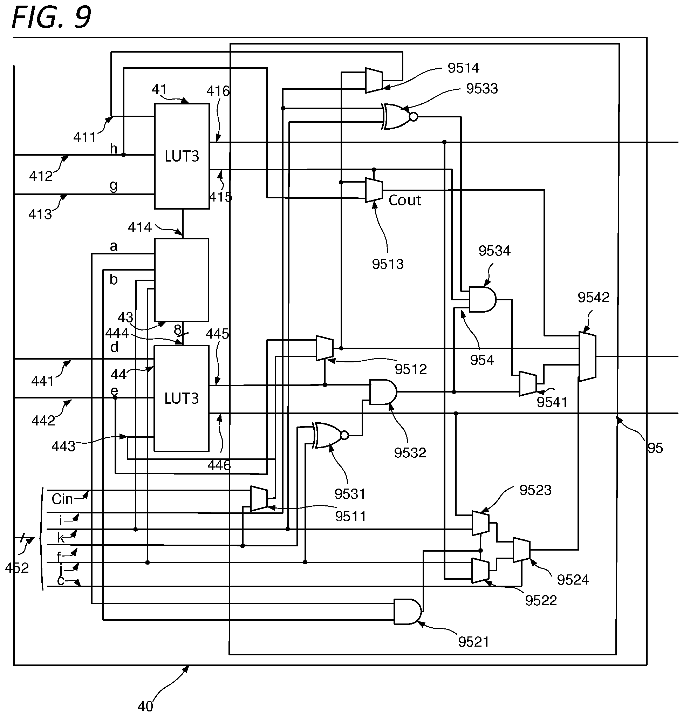

Fig 9 shows further detail of the combinatorial logic 45 of the embodiment described with reference to figure 4. In the embodiment of figure 9, the combinatorial logic is arranged to implement any of the functionalities described above with reference to figure 3 to 8. As shown, equivalent logical components are provided to implement the different functions described above, and additionally further logic supporting the selection of the desired function and where necessary the exclusion of redundant components. Specifically, the combinatorial logic 95 of this embodiment comprises a group of components 951x corresponding generally to carry propagation functions, a group of components 952x corresponding to multiplexing of the two LUTs, and group of components 953x relating to adding and comparison functions, and a group 954x relating to function selection. More specifically still, the group of components 951x corresponding generally to carry propagation functions comprises a multiplexer 9511 receiving two inputs f and Cin from the data inputs 452 and providing its output to the third data input 443 of the second LUT 44, a multiplexer 9512 receiving an input from multiplexer 9511 and from the second data input 442 of the second LUT 44 and switched by the output 445 of the second LUT 44 corresponding to the output of a multiplexer in the second row of the array of multiplexers constituting the LUT, a multiplexer 9513 receiving an input h from the data inputs 412 and the output of the multiplexer 9512, and a multiplexer 9514 receiving an input i from the data inputs 452 and the output of the multiplexer 9512 and providing its output to the third data input 411 of the second LUT 41. The group of components 952x corresponding to multiplexing of the two LUTs comprises an AND gate 9521 receiving inputs a and b, corresponding to two data inputs 452 of the programmable controller 43 and providing its output to the switching terminals of a first two input multiplexer 9522 and a second two input multiplexer 9523. The multiplexer 9522 receives a data input j from the data inputs 452 and the output 416 of the first LUT 41, and the multiplexer 9523 receives a data input k from the data inputs 452 and the output 446 of the first LUT 44. The multiplexers 9522 and 9523 provide their outputs to a further 2 input multiplexer 9524, which is switched by a data input c from the data inputs 452. The group of components 953x relating to adding equality functions comprises a first XNOR gate 9531 receiving two inputs j and f from the data inputs 452, and a second XNOR gate 9533 receiving two inputs I and k from the data inputs 452. The group further comprises an AND gate 9531 receiving inputs from the XNOR 9531 and the output 445 of the LUT 44, and a three input AND gate 9534 receiving inputs from the AND gate 9532, the XNOR gate 9533 and the output 415 of the LUT 41. The group 954x relating to function selection comprises a two input multiplexer 9541 receiving inputs from the AND gates 9534 and 9532, and a four input multiplexer 9542 receiving inputs from the multiplexer 9541, the multiplexer 9513, the multiplexer 9512 and the multiplexer 9524. The multiplexers 9511, 9541, 9542, 9514 are switched by values stored in respective memory cells (not shown) which are set at system initialization in the same way as LUT configuration cells or the configuration cells of the programmable controller.

To facilitate comparison of the different embodiments, the concordance between the elements described with regard to figure 9 on one hand and the other embodiments on the other can be set out as follows:

| Reference in figure 4 to 8 | Reference in Figure 9 |
|---|---|
| 551 | 9512 |
| | |
| 652 | 9511 |
| 651 | 9512 |
| 653 | 9513 |
| 654 | 9542 |
| | |
| 751 | 9521 |
| 752 | 9522 |
| 753 | 9523 |
| 754 | 9524 |
| | |
| 851 | 9531 |
| 852 | 9533 |
| 853 | 9532 |
| 854 | 9534 |

Thus, the programmable logic block may comprise a logic circuit comprising components for the implementation of a plurality of data processing functions, and further comprise one or more memory cells coupled respectively to components of said logic circuit so as to programmably select said specified data processing functions from said plurality of data processing functions.

It will be noted that in the embodiment of figure9, as well as in those of figures 5, 6 and 8, the LUTs 41 and 44 have two outputs, a first one 416 of the of outputs of the first LUT 41 corresponds to any of the inputs 414 multiplexed by each of the data inputs 411, 412, 413, and a second one 415 of the outputs corresponds to any of a subset of the inputs 414 multiplexed by a subset of the data inputs 411, 412, 413. Specifically as shown, four of the eight configuration inputs of the first LUT 41 are multiplexed by the two data entries 412 and 413 corresponding to the first and second rows of multiplexers constituting the LUT.

Similarly with respect to the second LUT 44, a first one of the outputs corresponds to any of the inputs 444 multiplexed by each of the data inputs 441, 442, 443, and a second one of the outputs of the second LUT 44 corresponds to any of a subset of the inputs multiplexed by a subset of the data inputs. Specifically as shown, four of the eight configuration inputs of the second LUT 44 are multiplexed by the two data entries 441 and 442 corresponding to the first and second rows of multiplexers constituting the LUT.

With respect to either or both of the LUTs 41, 44, the subset of configuration inputs to be multiplexed, and the subset of data entries used to select them may vary depending on the function to be implemented, and may differ between the two LUTs.

It will be appreciated that there are unlimited possible alternative configurations for the combinatorial logic, both in terms of alternative circuits of the functionality described above, and in terms of additional functionality that may be implemented to complement the functions provided by the LUTs. Meanwhile, some functions may be omitted or replaced.

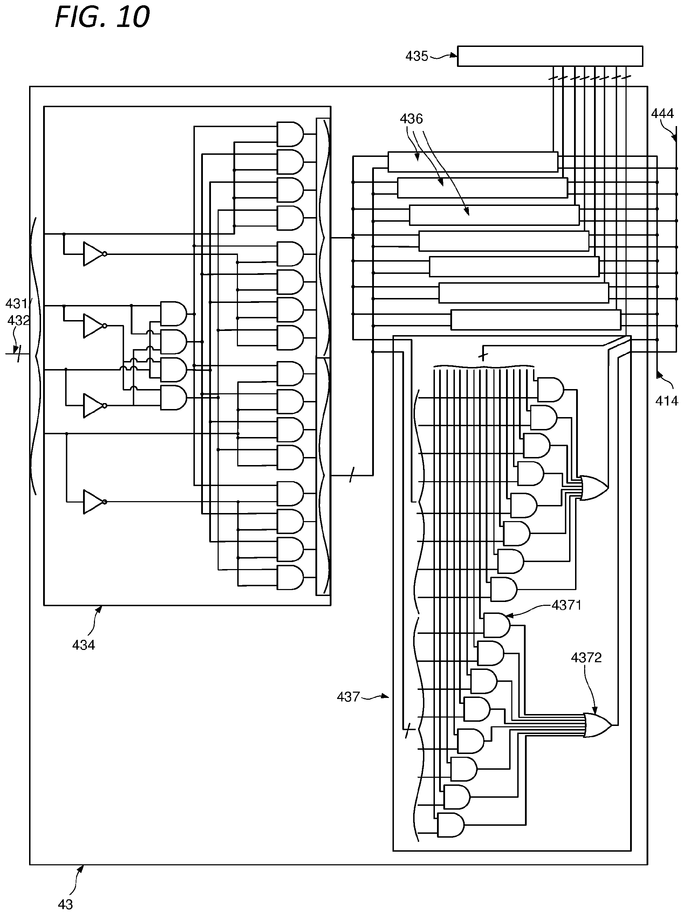

Figure 10 shows details of the implementation of the programmable controller according to an embodiment. As shown in figure 10, the programmable controller comprises a decoder 434 which decodes the 4 inputs 431/432 to two sets of 8 outputs. These two sets of signals are channelled to each of eight switching boxes 436, 437. The eight switching boxes 436, 437 are identical internally, and detail of the internal structure of the switching box 437 according to the present embodiment is shown in further detail. Each of these switching boxes comprises 16 AND gates 4371 in two groups of eight. Each AND gate in a given group of eight feeds its output to one of two OR gates 4372, which each provide one of the two outputs of the switching box. Each of these AND gates receives a second input from a respective memory cell in a memory block 435. By this means, it is possible for the programmable controller to produce any one of 16 predefined output patterns for the configurations of the LUTs 41 and 44, in response to a corresponding predefined signal on the input pins 431 and 432.

It will be appreciated that the described architecture of the programmable controller can be scaled to cater to the programming of different sized LUTs.

It will be appreciated that in some cases, depending on the logical functionalities to be implemented by the programmable logic block, it may be desirable to assign special roles to some or all of the input pins 431, 432, which may in turn constrain the values to which the outputs of the controller are set, for example as is the case of the embodiment described with reference to figure 7, in which the programmable logic block implements an 8 bit multiplexer, two inputs 432 of the programmable controller 43 are used as multiplexed inputs and the two LUTs 41 and 44 are configured as XNORs.

As such, the programmable controller comprises a decoder 434 configured to decode the eighth plurality of data entries 431/432. The programmable controller further comprises a plurality of switching boxes 436, 437, each said switching box receiving each of the decoded outputs of said decoder, and a respective one of said fifth plurality of configuration inputs, whereby each switching box provides an output value to one of the outputs connecting to each of the second plurality of configuration inputs and said fifth plurality of configuration inputs respectively, where the value of output 414, 444 is equal to the combination by a logical OR of the logical AND of each of said decoded output of said decoder with a respective one of said second plurality of configuration inputs.

In the particular embodiment illustrated, the number of switching boxes is equal to two to half the power of the number of the eighth plurality of data entries, which as shown is four, so that there are 8 switching boxes, each receiving the 16 configuration values and 16 configuration values. It will be appreciated that many different combinations of numbers of data values, configuration values and switching boxes may be envisaged depending on the number and size of the LUTs 41, 44 to be controlled, and the number and complexity of the programmable functions to be implemented.

It will be appreciated that many other architectures of the programmable controller can be envisaged that would provide equivalent functionality.

Figure 11 shows details of the implementation of the programmable controller according to a further embodiment. It will be appreciated that the functionality of the implantation of figure 11 is identical to that of figure 10.

As shown in figure 11, the programmable controller 43 comprises two banks of eight LUT3s, 438 and 439, each having 8 configuration inputs coupled to respective cells of a configuration memory 4300.

Each of LUTs in the first bank of LUTs 438 has three input lines 4381, 4382, 4383 connected in common to the three inputs of each LUT in the bank. These three input lines correspond to the inputs k, a and b of the programmable controller 43. Each of the LUTs in the second bank of LUTs 439 has three input lines 4391, 4392, 4393 connected in common to the three inputs of each LUT in the bank. These three input lines correspond to the inputs j, a and b of the programmable controller 43. The inputs a and b are thus in common for each of the 16 LUT3s composing the two banks 438, 439.

Each of LUTs in the first bank of LUTs 438 has an output line 4384. The resulting eight output lines correspond to the lines 414 providing the configuration inputs of the LUT 41. Each of LUTs in the second bank of LUTs 439 has an output line 4394. The resulting eight output lines correspond to the lines 444 providing the configuration inputs of the LUT 44.

Accordingly in operation, the functionality to be implemented by the programmable controller 43 can be defined with a wide degree of latitude by setting the values in the configuration memory 4300. According to a preferred embodiment, these values are set at system initialization.

Accordingly, the programmable controller may be considered to comprise a plurality of programmable controller LUTs, where each of the outputs 414 of the programmable controller corresponds to a respective output of one of said programmable controller LUTs, where the configuration inputs of each programmable controller LUT is coupled to a respective one of the configuration memory cells 4300.

Furthermore, the data inputs of the programmable controller LUTs may be coupled to the data entries of said programmable controller.

Still further the programmable controller as shown has four data entries k, a, b, j, of which two (a, b) are coupled in common to two respective data inputs the programmable controller LUTs, and a third entry (k) is coupled in common to a third respective input of each of the programmable controller LUTs whose output corresponds to a configuration input of said first LUT 41, and a fourth entry (j) is coupled in common to a third respective input of each of the programmable controller LUTs whose output corresponds to a configuration input of the second LUT 44.

It will be appreciated that this approach will be adapted to the number of inputs of the programmable controller, and the exact nature of the functions to be implemented as required.

While embodiments described with respect to figures 3 to 9 inclusive have presented the programmable controller 43 in association with various configurations of logic 45, it will be appreciated that the programmable controller 43 can provide a number of useful features will little or no supporting logic 45.

For example, the programmable controller 43 together with the LUTs 41 and 44 can be configured to augment the LUT capacity of the system, by using the inputs k, a, b and j of the programmable controller in addition to those of the LUTs 41, 44,to provide the functionality of larger LUTs. This expansion may be attributed to one LUT or the other, split between them, or shared by both as common inputs. By this means, the logic block can provide functionality as follows in addition to the basic 2 LUT3 configuration:

| **LUT config 1** | **LUT config 2** | **Number of Common Inputs** |
|---|---|---|
| LUT6 | LUT6 | 2 |
| LUT6 | LUT5 | 1 |
| LUT6 | LUT4 | 0 |
| LUT6 | LUT3 | 0 |
| LUT5 | LUT5 | 0 |
| LUT5 | LUT4 | 0 |
| LUT5 | LUT3 | 0 |
| LUT4 | LUT4 | 0 |
| LUT4 | LUT3 | 0 |
| LUT3 | LUT3 | 0 |

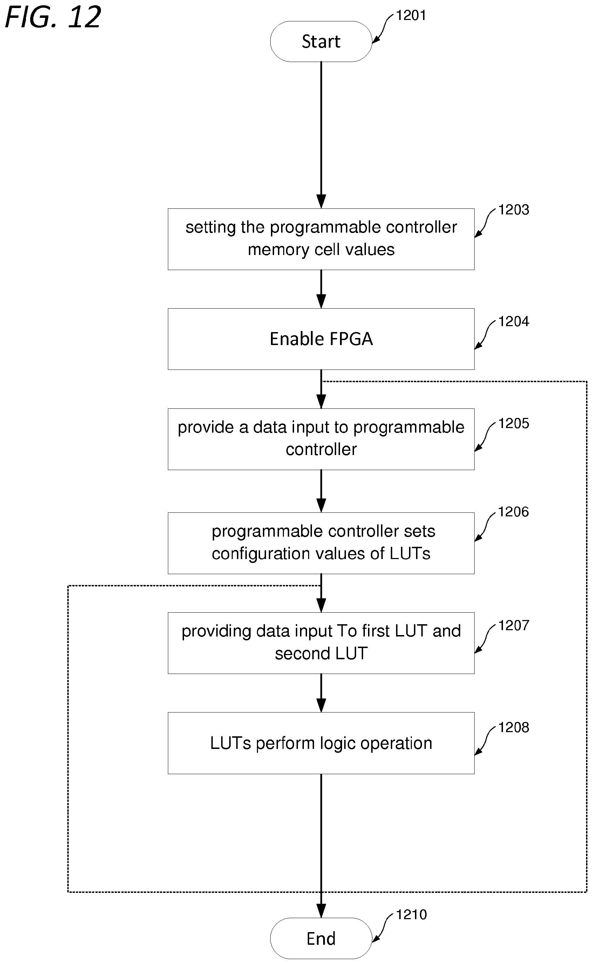

Figure 12 shows the steps of a method of operating an FPGA device in accordance with an embodiment.

This method is intended for operating an FPGA comprising a plurality of programmable logic blocks, for example as described above. As shown the method starts at step 1201 before proceeding to set the values of a first plurality of memory cells associated with the programmable controller at step 1203, before enabling the FPGA at step 1204. Now in an operational mode, the method provides a data input to the programmable controller at step 1205, as a result of which the programmable controller sets configuration values of the first LUT and the second LUT as a function of the data input and the values of the first plurality of memory cells at step 1206. It will be appreciated on the basis of the forgoing examples that this data input may comprise any number of bits depending on circuit configuration and the desired operation, not every input of each LUT will necessarily affect implementation of that operation, in which case the data input may include undefined or floating values for some inputs. In some cases inputs may be assumed to float high, or float low, whereby the data input may be limited to high or low values accordingly.

The method next proceeds to step 1207 at which a data input is provided to the first LUT and said second LUT. It will be appreciated on the basis of the forgoing examples that this data input may comprise any number of bits depending on circuit configuration and the desired operation, not every input of each LUT will necessarily affect implementation of that operation, in which case the data input may include undefined or floating values for some inputs. In some cases inputs may be assumed to float high, or float low, whereby the data input may be limited to high or low values accordingly.

At step 1208 the first LUT and second LUT perform respective logic operations on the respective data inputs provided at step 1207 as a function of the configuration values set by said programmable controller, then outputs the result of said further logic operation before terminating at step 1210.

It will be appreciated that in many implementations the method may loop back to step 1207 to repeat the logic operation on new input values any number of times before operation is terminated.

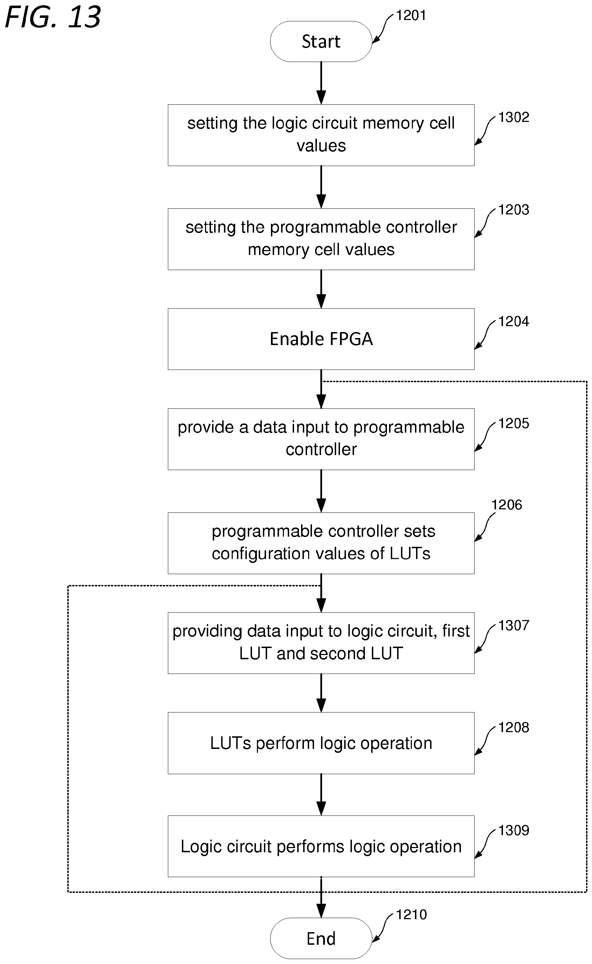

It will be appreciated that in many implementations the method may loop back to step 1205 to select a new mode of operation from the programmable controller on the basis of new input values, causing the programmable controller to change the configuration values of the LUTs any number of times before operation is terminated. Figure 13 shows the steps of a method of operating an FPGA device in accordance with an embodiment.

The method of figure 13 is a further development of that of figure 12, and like numbered references correspond to similar steps, in which the method extends to the operation of a logic circuit such as logic circuit 35, 45, 55, 65, 75, 85, 95 or other embodiments mentioned herein or otherwise.

This method is intended for operating an FPGA comprising a plurality of programmable logic blocks, for example as described above. As shown the method starts at step 1201 before proceeding to set the values of a second plurality of memory cells associated with the configuration inputs of the logic circuit at step 1302. The method next sets the values of a first plurality of memory cells associated with the programmable controller at step 1203, before enabling the FPGA at step 1204. Now in an operational mode, the method provides a data input to the programmable controller at step 1205, as a result of which the programmable controller sets configuration values of the first LUT and the second LUT as a function of the data input and the values of the first plurality of memory cells at step 1206. It will be appreciated on the basis of the forgoing examples that this data input may comprise any number of bits depending on circuit configuration and the desired operation, not every input of each LUT will necessarily affect implementation of that operation, in which case the data input may include undefined or floating values for some inputs. In some cases inputs may be assumed to float high, or float low, whereby the data input may be limited to high or low values accordingly.

The method next proceeds to step 1307 at which a data input is provided to the logic circuit, the first LUT and said second LUT. It will be appreciated on the basis of the forgoing examples that this data input may comprise any number of bits depending on circuit configuration and the desired operation, not every input of each LUT will necessarily affect implementation of that operation, in which case the data input may include undefined or floating values for some inputs. In some cases inputs may be assumed to float high, or float low, whereby the data input may be limited to high or low values accordingly.

At step 1208 the first LUT and second LUT perform respective logic operations on the respective data inputs provided at step 1207 as a function of the configuration values set by said programmable controller, the result of which is output to the logic circuit. At step 1309 the logic circuit then performs a further logic operation on the outputs of said first LUT and said second LUT and the data received at step 1307 as a function of the values of said second plurality of memory; and then outputs the result of said further logic operation before terminating at step 1210.

It will be appreciated that in many implementations the method may loop back to step 1307 to repeat the logic operation on new input values any number of times before operation is terminated.

It will be appreciated that in many implementations the method may loop back to step 1205 to select a new mode of operation from the programmable controller on the basis of new input values, causing the programmable controller to change the configuration values of the LUTs any number of times before operation is terminated.

It will be appreciated on the basis of the forgoing examples that in some cases the LUTs may perform a null operation, or that their output may not have any effect on the results generated by the logic circuit (so that the logic circuit performs it operation solely on the data inputs received at step 1307), and that in other cases the logic circuit may perform a null operation on the outputs of the LUT, or simply pass through the results from the LUTs to its output without modification, in which case the output result will depend solely on the operation of the LUTs on the data input received at step 1307 and the configuration values received at step 1206. It will further be appreciated that in some cases only on LUT or the other will contribute to a given operation. As discussed above, the two LUTs may be of any size, and be of different sizes, and may exceed two in number.

It will be appreciated that the steps of the method described with reference to figures 12 or 13 will lead to a characteristic datastream comprising values selected to implement the different steps, depending on the functions to be implemented for example as described above.

It will be appreciated that the steps 1302 and 1203 may be implemented in any order, and that them may be implemented partially or wholly in parallel.

Accordingly, there is provided a programmable logic block for a FPGA comprising two Lookup Tables (LUT) 41, 44. The configuration information for these LUTs 41, 44 is provided by a programmable controller 43, which itself incorporates LUT functionality. This intermediate layer of LUT functionality provides a means to programmatically control the behaviour of the primary LUTs 41, 44 in an operational mode, on the basis of settings made during an initialization mode. Certain embodiments also incorporate a logic circuit 35, which together with the programmable behaviour of the primary LUTs provides a means for efficiently implementing a number of common logic functions in including adders, multiplexers, parity and extended LUT and multiplexer functions.

It will be understood that the configurations and/or approaches described herein are exemplary in nature, and that these specific embodiments or examples are not to be considered in a limiting sense, because numerous variations are possible as defined in the appended claims.

## Claims

1. A programmable logic block (30) comprising:
a first LUT (31, 41) having a first plurality of data inputs (311),
a second plurality of configuration inputs (312; 414), and
a third plurality of outputs (313), and
a second LUT (32; 42) having a
fourth plurality of data inputs (341) and
a fifth plurality of configuration inputs (342; 444), and
a sixth plurality of outputs (343),
said programmable logic block (30) **characterized by** further comprising:
a programmable controller (33;43) having
a respective output connecting to each of said second plurality of configuration inputs (312; 414) and each of said fifth plurality of configuration inputs (342; 444),
a seventh plurality of configuration memory cells (4300; 435), and
an eighth plurality of data entries (432),
wherein the value of each of said second plurality of configuration inputs (312; 414) and said fifth plurality of configuration inputs (342; 444) is dictated by the value present on each of said eighth plurality of data entries(432) together with the value of said seventh plurality of configuration memory cells (4300;435) in a predetermined manner.

2. The programmable logic block of claim 1 further comprising a logic circuit (35; 45) connected to each of said third plurality of outputs (313) and said sixth plurality of outputs (343), said logic circuit (35; 45) adapted to combine said outputs (313, 343) to implement a specified data processing function.

3. The programmable logic block of claim 2 wherein said logic circuit comprises components for the implementation of a plurality of data processing functions, and further comprises one or more configuration memory cells coupled respectively to components of said logic circuit so as to programmably select said specified data processing functions from said plurality of data processing functions.

4. The programmable logic block of claim 2 or 3 claim wherein said plurality of data processing functions includes the functionality of a 1 bit full adder.

5. The programmable logic block of any of claims 2 to 4 claim wherein said plurality of data processing functions includes the functionality of a 2 bit full adder.

6. The programmable logic block of any of claims 2 to 5 claim wherein said plurality of data processing functions includes the functionality of a multiplexer.

7. The programmable logic block of any of claims 2 to 6 wherein said plurality of data processing functions includes the functionality of a Lookup table whose having a number of data inputs greater than said second plurality.

8. The programmable logic block of any preceding claim in which said programmable controller (33; 43) comprises a plurality of programmable controller LUTs (438, 439), and where each of the outputs of said programmable controller corresponds to a respective output of one of said programmable controller LUTs (438, 439), where the configuration inputs of each said programmable controller LUT is coupled to a respective one of said seventh plurality of configuration memory cells (4300).

9. The programmable logic block of claim 8 wherein the data inputs of said programmable controller LUTs (438, 439), are coupled to said eighth plurality of data entries of said programmable controller (432).

10. The programmable logic block of claim 9 wherein said programmable controller further comprises a decoder (434) configured to decode said eighth plurality of data entries (432), wherein said programmable controller (33;43) further comprises a plurality of switching boxes (436, 437), each said switching box (436, 437) receiving each of the decoded outputs of said decoder (434), and a respective one of said seventh plurality of said configuration memory cells (4300; 435), whereby each switching box provides an output value to one of said outputs connecting to each of said second plurality of configuration inputs (312; 414) and said fifth plurality of configuration inputs (342; 444) respectively, where the value of said output is equal to the combination by a logical OR of the logical AND of each of said decoded output of said decoder with a respective one of said second plurality of configuration inputs.

11. The programmable logic block of claim 9 or 10 wherein said programmable controller(33;43) has four data entries, of which two are coupled in common to two respective data inputs of each of said programmable controller LUTs (438, 439), and a third one of said entries is coupled in common to a third respective input of each of said programmable controller LUTs (438, 439), whose output corresponds to a configuration input of said first LUT (31;41), and a fourth one of said entries is coupled in common to a third respective input of each of said programmable controller LUTs (438, 439), whose output corresponds to a configuration input of said second LUT (34;44).

12. The programmable logic block of any preceding claim wherein a first one of said third plurality of outputs (313) of said first LUT (31 ;41) corresponds to any of said second plurality of inputs (312; 414) multiplexed by each of said first plurality of data inputs, and a second one of said third plurality of outputs of said first LUT corresponds to any of a subset of said second plurality of inputs multiplexed by a subset of said first plurality of data inputs (311), or a first one of said sixth plurality of outputs (343) of said second LUT (34;44) corresponds to any of said fifth plurality of inputs (342; 444), multiplexed by each of said fourth plurality of data inputs (341), and a second one of said sixth plurality of outputs(343) of said second LUT (34;44) corresponds to any of a subset of said fifth plurality of inputs (342; 444) multiplexed by a subset of said fourth plurality of data inputs (341).

13. A method of operating an FPGA device comprising
a first LUT (31;41),
a second LUT (34;44), and
a programmable controller (33;43);
said method comprising the steps of:
setting the values of a first plurality of memory cells (4300; 435) associated with said programmable controller (33;43);
enabling said FPGA;
providing a data input to said programmable controller (33;43), whereby said programmable controller (33;43) sets configuration values of said first LUT (31;41) and said second LUT (33:43) as a function of said data input and the values of said first plurality of memory cells (4300;435);
providing a data input to said first LUT (31 ;41) and said second LUT (34;44);
said first LUT (31;41) and said second LUT (34;44) performing respective logic operations on the respective data inputs provided at said step of providing a data input as a function of the configuration values set by said programmable controller (33;44); and
outputting the result of said respective logic operations.

14. The method of claim 13, wherein said FPGA device further comprises a logic circuit (35;45), and wherein said method comprises the further steps of:
prior to said step of enabling said FPGA, setting the values of a second plurality of memory cells associated with the configuration inputs of said logic circuit (33;43);
wherein said step of providing a data input to said first LUT (31;41) and said second LUT (34;44) further comprises providing a data input to said logic circuit (33;44);
said logic circuit (33;44);performing a further logic operation on the outputs of said first LUT and said second LUT as a function of the values of said second plurality of memory cells (4300;435); and
outputting the result of said further logic operation.

15. A configuration datastream comprising configuration values selected to implement the method of claim 13 or 14.

## Patentansprüche

1. Programmierbarer Logikblock (30), umfassend:
eine erste LUT (31, 41) mit einer ersten Vielzahl von Dateneingängen (311),
einer zweiten Vielzahl von Konfigurationseingängen (312; 414), und
einer dritten Vielzahl von Ausgängen (313), und
eine zweite LUT (32; 42) mit
einer vierten Vielzahl von Dateneingängen (341), und
einer fünften Vielzahl von Konfigurationseingängen (342; 444), und
einer sechsten Vielzahl von Ausgängen (343),
wobei der programmierbare Logikblock (30) **dadurch gekennzeichnet ist, dass** er ferner umfasst:
eine programmierbare Steuerung (33; 43) mit
einem jeweiligen Ausgang, der sich mit jedem der zweiten Vielzahl von Konfigurationseingängen (312; 414) und jedem der fünften Vielzahl von Konfigurationseingängen (342; 444) verbindet,
einer siebten Vielzahl von Konfigurationsspeicherzellen (4300; 435), und
einer achten Vielzahl von Dateneinträgen (432),
wobei der Wert von jedem der zweiten Vielzahl von Konfigurationseingängen (312; 414) und der fünften Vielzahl von Konfigurationseingängen (342; 444) durch den Wert diktiert wird, der an jedem der achten Vielzahl von Dateneinträgen (432) vorhanden ist, zusammen mit dem Wert der siebten Vielzahl von Konfigurationsspeicherzellen (4300; 435), in einer im Voraus bestimmten Weise.

2. Programmierbarer Logikblock nach Anspruch 1, ferner umfassend eine Logikschaltung (35; 45), verbunden mit jedem der dritten Vielzahl von Ausgängen (313) und der sechsten Vielzahl von Ausgängen (343), wobei die Logikschaltung (35; 45) angepasst ist zum Kombinieren der Ausgänge (313, 343), um eine spezifizierte Datenverarbeitungsfunktion zu implementieren.

3. Programmierbarer Logikblock nach Anspruch 2, wobei die Logikschaltung Komponenten zur Implementierung einer Vielzahl von Datenverarbeitungsfunktionen umfasst und ferner eine oder mehrere Konfigurationsspeicherzellen umfasst, die jeweils an Komponenten der Logikschaltung gekoppelt sind, um die spezifizierten Datenverarbeitungsfunktionen aus der Vielzahl von Datenverarbeitungsfunktionen programmierbar auszuwählen.

4. Programmierbarer Logikblock nach Anspruch 2 oder Anspruch 3, wobei die Vielzahl von Datenverarbeitungsfunktionen die Funktionalität eines 1-Bit-Volladdierers enthält.

5. Programmierbarer Logikblock nach einem der Ansprüche 2 bis 4, wobei die Vielzahl von Datenverarbeitungsfunktionen die Funktionalität eines 2-Bit-Volladdierers enthält.

6. Programmierbarer Logikblock nach einem der Ansprüche 2 bis 5, wobei die Vielzahl von Datenverarbeitungsfunktionen die Funktionalität eines Multiplexers enthält.

7. Programmierbarer Logikblock nach einem der Ansprüche 2 bis 6, wobei die Vielzahl von Datenverarbeitungsfunktionen die Funktionalität einer Nachschlagetabelle enthält, die eine Anzahl von Dateneingängen größer als die zweite Vielzahl aufweist.

8. Programmierbarer Logikblock nach einem der vorstehenden Ansprüche, wobei die programmierbare Steuerung (33; 43) eine Vielzahl von programmierbaren Steuerung-LUTs (438, 439) umfasst und worin jeder der Ausgänge der programmierbaren Steuerung mit einem jeweiligen Ausgang einer der programmierbaren Steuerung-LUTs (438, 439) korrespondiert, worin die Konfigurationseingänge jeder der programmierbaren Steuerung-LUT an eine jeweilige eine der siebten Vielzahl von Konfigurationsspeicherzellen (4300) gekoppelt sind.

9. Programmierbarer Logikblock nach Anspruch 8, wobei die Dateneingänge der programmierbaren Steuerung-LUTs (438, 439) an die achte Vielzahl von Dateneinträgen der programmierbaren Steuerung (432) gekoppelt sind.

10. Programmierbarer Logikblock nach Anspruch 9, wobei die programmierbare Steuerung ferner einen Decodierer (434) umfasst, konfiguriert zum Decodieren der achten Vielzahl von Dateneinträgen (432), wobei die programmierbare Steuerung (33; 43) ferner eine Vielzahl von Schaltboxen (436, 437), wobei jede Schaltbox (436, 437) jeden der decodierten Ausgänge des Decodierers (434) empfängt, und einen jeweiligen einen der siebten Vielzahl der Konfigurationsspeicherzellen (4300; 435) umfasst, wodurch jede Schaltbox einem der Ausgänge, die sich mit jedem der zweiten Vielzahl von Konfigurationseingängen (312; 414) beziehungsweise. der fünften Vielzahl von Konfigurationseingängen (342; 444) verbinden, einen Ausgangswert bereitstellt, worin der Wert des Ausgangs gleich der Kombination durch ein logisches ODER des logischen UND von jedem des decodierten Ausgangs des Decodierers mit einem jeweiligen einen der zweiten Vielzahl von Konfigurationseingängen ist.

11. Programmierbarer Logikblock nach Anspruch 9 oder 10, wobei die programmierbare Steuerung (33; 43) vier Dateneinträge aufweist, von denen zwei an zwei jeweilige Dateneingänge jeder der programmierbaren Steuerung-LUTs (438, 439) gemeinsam gekoppelt sind und ein dritter einer der Einträge an einen dritten jeweiligen Eingang jeder der programmierbaren Steuerung-LUTs (438, 439), deren Ausgang mit einem Konfigurationseingang der ersten LUT (31; 41) korrespondiert, gemeinsam gekoppelt ist und ein vierter einer der Einträge an einen dritten jeweiligen Eingang jeder der programmierbaren Steuerung-LUTs (438, 439), deren Ausgang mit einem Konfigurationseingang der zweiten LUT (34; 44) korrespondiert, gemeinsam gekoppelt ist.

12. Programmierbarer Logikblock nach einem der vorstehenden Ansprüche, wobei ein erster einer der dritten Vielzahl von Ausgängen (313) der ersten LUT (31; 41) mit beliebigen der zweiten Vielzahl von Eingängen (312; 414) korrespondiert, die von jedem der ersten Vielzahl von Dateneingängen gemultiplext wird, und ein zweiter einer der dritten Vielzahl von Ausgängen der ersten LUT mit beliebigen einer Teilmenge der zweiten Vielzahl von Eingängen korrespondiert, die von einer Teilmenge der ersten Vielzahl von Dateneingängen (311) gemultiplext wird, oder ein erster einer der sechsten Vielzahl von Ausgängen (343) der zweiten LUT (34; 44) mit beliebigen der fünften Vielzahl von Eingängen (342; 444) korrespondiert, die, von jedem der vierten Vielzahl von Dateneingängen (341) gemultiplext wird, und ein zweiter einer der sechsten Vielzahl von Ausgängen (343) der zweiten LUT (34; 44) mit beliebigen einer Teilmenge der fünften Vielzahl von Eingängen (342; 444) korrespondiert, die von einer Teilmenge der vierten Vielzahl von Dateneingängen (341) gemultiplext wird.

13. Verfahren zum Betreiben einer FPGA-Vorrichtung, umfassend
eine erste LUT (31; 41),
eine zweite LUT (34; 44) und
eine programmierbare Steuerung (33; 43);
wobei das Verfahren die folgenden Schritte umfasst:
Setzen der Werte einer ersten Vielzahl von Speicherzellen (4300; 435), die mit der programmierbaren Steuerung (33; 43) assoziiert sind;
Aktivieren der FPGA;
Bereitstellen, der programmierbaren Steuerung (33; 43), eines Dateneingangs, wobei die programmierbare Steuerung (33; 43) Konfigurationswerte der ersten LUT (31; 41) und der zweiten LUT (33; 43) als eine Funktion des Dateneingangs und der Werte der ersten Vielzahl von Speicherzellen (4300; 435) setzt;
Bereitstellen, der ersten LUT (31; 41) und der zweiten LUT (34; 44), von Dateneingang;
wobei die erste LUT (31; 41) und die zweite LUT (34; 44) jeweilige Logikoperationen an den jeweiligen Dateneingängen durchführen, bereitgestellt in dem Schritt des Bereitstellens eines Dateneingangs als eine Funktion der durch die programmierbare Steuerung (33; 44) gesetzten Konfigurationswerte; und
Ausgeben des Ergebnisses der jeweiligen Logikoperationen.

14. Verfahren nach Anspruch 13, wobei die FPGA-Vorrichtung ferner eine Logikschaltung (35; 45) umfasst und wobei das Verfahren die folgenden weiteren Schritte umfasst:
vor dem Schritt des Aktivierens der FPGA Setzen der Werte einer zweiten Vielzahl von Speicherzellen, die mit den Konfigurationseingängen der Logikschaltung (33; 43) assoziiert sind;
wobei der Schritt des Bereitstellens, der ersten LUT (31; 41) und der zweiten LUT (34; 44), eines Dateneingangs ferner umfasst, der Logikschaltung (33; 44) einen Dateneingang bereitzustellen;
wobei die Logikschaltung (33; 44) eine weitere Logikoperation an den Ausgängen der ersten LUT und der zweiten LUT als eine Funktion der Werte der zweiten Vielzahl von Speicherzellen (4300; 435) durchführt; und
Ausgeben des Ergebnisses der weiteren Logikoperation.

15. Konfigurationsdatenstrom, umfassend Konfigurationswerte, die zum Implementieren des Verfahrens nach Anspruch 13 oder 14 ausgewählt werden.

## Revendications

1. Bloc logique programmable (30) comprenant :
une première LUT, (31, 41) présentant une première pluralité d'entrées de données (311) ;
une deuxième pluralité d'entrées de configuration (312 ; 414) ; et
une troisième pluralité de sorties (313) ; et
une seconde LUT (32 ; 42) présentant
une quatrième pluralité d'entrées de données (341) ; et
une cinquième pluralité d'entrées de configuration (342 ; 444) ; et
une sixième pluralité de sorties (343) ;
ledit bloc logique programmable (30) étant **caractérisé en ce qu'**il comprend en outre :
un contrôleur programmable (33 ; 43) présentant
une sortie respective se connectant à chacune de ladite deuxième pluralité d'entrées de configuration (312 ; 414) et à chacune de ladite cinquième pluralité d'entrées de configuration (342 ; 444) ;
une septième pluralité de cellules de mémoire de configuration (4300 ; 435) ; et
une huitième pluralité d'entrées de données (432) ;
dans lequel la valeur de chacune de ladite deuxième pluralité d'entrées de configuration (312 ; 414) et de ladite cinquième pluralité d'entrées de configuration (342 ; 444) est dictée par la valeur présente sur chacune de ladite huitième pluralité d'entrées de données (432) conjointement avec la valeur de ladite septième pluralité de cellules de mémoire de configuration (4300 ; 435) d'une manière prédéterminée.

2. Bloc logique programmable selon la revendication 1, comprenant en outre un circuit logique (35 ; 45) connecté à chacune de ladite troisième pluralité de sorties (313) et de ladite sixième pluralité de sorties (343), ledit circuit logique (35 ; 45) étant apte à combiner lesdites sorties (313, 343) en vue de mettre en œuvre une fonction de traitement de données spécifiée.

3. Bloc logique programmable selon la revendication 2, dans lequel ledit circuit logique comprend des composants pour la mise en œuvre d'une pluralité de fonctions de traitement de données, et comprend en outre une ou plusieurs cellules de mémoire de configuration couplées respectivement à des composants dudit circuit logique pour sélectionner de manière programmable lesdites fonctions de traitement de données spécifiées parmi ladite pluralité de fonctions de traitement de données.

4. Bloc logique programmable selon la revendication 2 ou 3, dans lequel ladite pluralité de fonctions de traitement de données inclut la fonctionnalité d'un additionneur complet à 1 bit.

5. Bloc logique programmable selon l'une quelconque des revendications 2 à 4, dans lequel ladite pluralité de fonctions de traitement de données inclut la fonctionnalité d'un additionneur complet à 2 bits.

6. Bloc logique programmable selon l'une quelconque des revendications 2 à 5, dans lequel ladite pluralité de fonctions de traitement de données inclut la fonctionnalité d'un multiplexeur.

7. Bloc logique programmable selon l'une quelconque des revendications 2 à 6, dans lequel ladite pluralité de fonctions de traitement de données inclut la fonctionnalité d'une table de consultation dont le nombre d'entrées de données est supérieur à ladite deuxième pluralité.

8. Bloc logique programmable selon l'une quelconque des revendications précédentes, dans lequel ledit contrôleur programmable (33 ; 43) comprend une pluralité de LUTs de contrôleur programmable (438, 439), et où chacune des sorties dudit contrôleur programmable correspond à une sortie respective de l'une desdites LUTs de contrôleur programmable (438, 439), où les entrées de configuration de chaque dite LUT de contrôleur programmable sont couplées à une respective de ladite septième pluralité de cellules de mémoire de configuration (4300).

9. Bloc logique programmable selon la revendication 8, dans lequel les entrées de données desdites LUT de contrôleur programmable (438, 439) sont couplées à ladite huitième pluralité d'entrées de données dudit contrôleur programmable (432).

10. Bloc logique programmable selon la revendication 9, dans lequel ledit contrôleur programmable comprend en outre un décodeur (434) configuré pour décoder ladite huitième pluralité d'entrées de données (432), dans lequel ledit contrôleur programmable (33 ; 43) comprend en outre une pluralité de boîtiers de commutation (436, 437), chaque dit boîtier de commutation (436, 437) recevant chacune des sorties décodées dudit décodeur (434), et une respective de ladite septième pluralité desdites cellules de mémoire de configuration (4300 ; 435), moyennant quoi chaque boîtier de commutation fournit une valeur de sortie à l'une desdites sorties se connectant à chacune de ladite deuxième pluralité d'entrées de configuration (312 ; 414) et de ladite cinquième pluralité d'entrées de configuration (342 ; 444), respectivement, où la valeur de ladite sortie est égale à la combinaison, par un opérateur OU logique de l'opérateur ET logique, de chaque dite sortie décodée dudit décodeur avec une respective de ladite deuxième pluralité d'entrées de configuration.

11. Bloc logique programmable selon la revendication 9 ou 10, dans lequel ledit contrôleur programmable (33 ; 43) présente quatre entrées de données, dont deux sont couplées en commun à deux entrées de données respectives de chacune desdites LUTs de contrôleur programmable (438, 439), et une troisième desdites entrées est couplée en commun à une troisième entrée respective de chacune desdites LUTs de contrôleur programmable (438, 439), dont la sortie correspond à une entrée de configuration de ladite première LUT (31 ; 41), et une quatrième desdites entrées est couplée en commun à une troisième entrée respective de chacune desdites LUT de contrôleur programmable (438, 439), dont la sortie correspond à une entrée de configuration de ladite seconde LUT (34 ; 44).

12. Bloc logique programmable selon l'une quelconque des revendications précédentes, dans lequel une première de ladite troisième pluralité de sorties (313) de ladite première LUT (31 ; 41) correspond à une quelconque de ladite deuxième pluralité d'entrées (312 ; 414) multiplexée par chacune de ladite première pluralité d'entrées de données, et l'une deuxième de ladite troisième pluralité de sorties de ladite première LUT correspond à une quelconque d'un sous-ensemble de ladite deuxième pluralité d'entrées multiplexée par un sous-ensemble de ladite première pluralité d'entrées de données (311), ou une première de ladite sixième pluralité de sorties (343) de ladite seconde LUT (34 ; 44) correspond à une quelconque de ladite cinquième pluralité d'entrées (342 ; 444), multiplexée par chacune de ladite quatrième pluralité d'entrées de données (341), et une deuxième de ladite sixième pluralité de sorties (343) de ladite seconde LUT (34 ; 44) correspond à une quelconque d'un sous-ensemble de ladite cinquième pluralité d'entrées (342 ; 444) multiplexée par un sous-ensemble de ladite quatrième pluralité d'entrées de données (341).

13. Procédé de fonctionnement d'un dispositif FPGA, comprenant :
une première LUT (31 ; 41) ;
une seconde LUT (34 ; 44) ; et
un contrôleur programmable (33 ; 43) ;
ledit procédé comprenant les étapes ci-dessous consistant à :
définir les valeurs d'une première pluralité de cellules de mémoire (4300 ; 435) associées audit contrôleur programmable (33 ; 43) ;
activer ledit FPGA ;
fournir une entrée de données audit contrôleur programmable (33 ; 43), moyennant quoi ledit contrôleur programmable (33 ; 43) définit des valeurs de configuration de ladite première LUT (31 ; 41) et de ladite seconde LUT (33 ; 43) en fonction de ladite entrée de données, et des valeurs de ladite première pluralité de cellules de mémoire (4300 ; 435) ;
fournir une entrée de données à ladite première LUT (31 ; 41) et à ladite seconde table LUT (34 ; 44) ;
ladite première LUT (31 ; 41) et ladite seconde LUT (34 ; 44) mettant en œuvre des opérations logiques respectives sur les entrées de données respectives fournies au cours de ladite étape de fourniture d'une entrée de données, en fonction des valeurs de configuration définies par ledit contrôleur programmable (33 ; 44) ; et
fournir en sortie le résultat desdites opérations logiques respectives.

14. Procédé selon la revendication 13, dans lequel ledit dispositif FPGA comprend en outre un circuit logique (35 ; 45), et dans lequel ledit procédé comprend les étapes supplémentaires consistant à :
avant ladite étape d'activation dudit FPGA, définir les valeurs d'une deuxième pluralité de cellules de mémoire associées aux entrées de configuration dudit circuit logique (33 ; 43) ;
dans lequel ladite étape de fourniture d'une entrée de données à ladite première LUT (31 ; 41) et à ladite seconde LUT (34 ; 44) consiste en outre à fournir une entrée de données audit circuit logique (33 ; 44) ;
ledit circuit logique (33 ; 44) mettant en œuvre une opération logique supplémentaire sur les sorties de ladite première LUT et de ladite seconde LUT, en fonction des valeurs de ladite deuxième pluralité de cellules de mémoire (4300 ; 435) ; et
fournir en sortie le résultat de ladite opération logique supplémentaire.

15. Flux de données de configuration comprenant des valeurs de configuration sélectionnées pour mettre en œuvre le procédé selon la revendication 13 ou 14.
